# EUROPÄISCHE PATENTSCHRIFT

(11) **EP 3 044 040 B1**
(45) Veröffentlichungstag und Bekanntmachung des Hinweises auf die Patenterteilung: **21.06.2017**
(21) Anmeldenummer: 13791905.6
(22) Anmeldetag: 13.09.2013
(51) Int. Cl.: B60R 16/023, E05B 85/02, H05K 5/00, E05B 81/54

(54) **KOMPONENTENTRÄGER**
COMPONENT CARRIER
SUPPORT DE COMPOSANTS

(43) Veröffentlichungstag der Anmeldung: 20.07.2016
(73) Patentinhaber: Kiekert Aktiengesellschaft, 42579 Heiligenhaus (DE)
(72) Erfinder: MITTELBACH, Stephan, D-42551 Velbert (DE)
(86) Internationale Anmeldenummer: PCT/DE2013/000524
(87) Internationale Veröffentlichungsnummer: WO 2015/035966

(56) Entgegenhaltungen:
- EP-A1- 0 894 924
- EP-A1- 1 030 014
- EP-A2- 0 686 745
- WO-A2-2013/098379
- DE-A1- 3 903 818
- DE-A1- 19 701 950
- FR-A1- 2 839 416
- GB-A- 2 254 880
- US-A- 5 360 351

## Beschreibung

Die Erfindung betriff einen Komponententräger zur Aufnahme von elektrischen/elektronischen Bauelementen in insbesondere Kraftfahrzeugtürschlössern, mit zumindest einem elektrischen Anschluss, ferner mit wenigstens einem Trägerelement, und mit einem oder mehreren elektrischen Leitern zur elektrischen Kontaktierung des Anschlusselementes und/oder eines elektrischen Bauteils.

Ein Komponententräger des eingangs beschriebenen Aufbau wird beispielsweise in der Gebrauchsmusterschrift DE 203 07 111 U1 der Anmelderin vorgestellt. Solche Komponententräger sind oftmals wannenartig ausgelegt, so dass die von dem Trägerelement aufgenommenen bzw. hieran angebrachten elektrischen und elektronischen Bauelemente ebenso wie die einen oder mehreren elektrischen Leiter bzw. ein an dieser Stelle regelmäßig vorgesehenes Leiterbahngebilde mit Vergussmasse umhüllt werden können. Die Vergussmasse sorgt für eine dauerhaft hohe Funktionssicherheit und Betriebsstabilität.

Als Folge hiervon kann der bestückte und mit der Vergussmasse ausgerüstete Komponententräger problemlos in ein zugehöriges Kraftfahrzeugtürschloss-gehäuse eingebaut werden. Das Anschlusselement sorgt in diesem Kontext im Regelfall dafür, dass die elektrischen/elektronischen Bauelemente auf oder an dem Komponententräger im Innern des Kraftfahrzeugtürschlossgehäuses mit einer außerhalb vorgesehenen Steuereinheit kommunizieren können. Dazu ist das Anschlusselement regelmäßig als Kontaktbuchse ausgelegt, in welche ein Stecker mit Anschlussleitungen eingesteckt wird. Die Anschlussleitungen stehen mit der Steuereinheit in Verbindung, die sich beispielsweise im Innern einer das Kraftfahrzeugtürschloss aufweisenden Kraftfahrzeugtür oder einer Kraftfahrzeugkarosserie befindet.

In diesem Zusammenhang lehrt die EP 1 771 052 A2 einen Komponententräger zur Aufnahme elektrischer/elektronischer Bauelemente in Kraftfahrzeugtürschlössern, welcher mit zwei oder mehr Anschlusselementen ausgerüstet ist. Die Anschlusselemente können wahlweise oder gemeinsam aktiviert werden, indem ein zu dem Aktivierungswunsch korrespondierendes einbaufertiges Leiterbahngebilde ausgewählt wird. Alternativ hierzu kann aber auch ein Basis-Leiterbahngebilde dem Aktivierungswunsch entsprechend zu dem einbaufertigen Leiterbahngebilde modifiziert werden. Auf diese Weise lassen sich möglichst viele gleich aufgebaute Bauteile auch bei unterschiedlichen Anforderungen realisieren. Dadurch wird eine insgesamt standardisierte Herstellung zur Verfügung gestellt. EP 0 686 745 A2 offenbart einen Komponententräger gemäß dem Oberbegriff des Anspruchs 1.

Der Stand der Technik hat sich insgesamt bewährt, führt jedoch zu einbaufertigen und folglich vergossenen Komponententrägern nicht unerheblicher Abmessungen. Außerdem sind die Anforderungen an das Anschlusselement davon abhängig, welche elektrischen/elektronischen Bauteile am Komponententräger angebracht sind. Sofern an dieser Stelle mit einem zumindest teilweise modularen Aufbau gearbeitet wird, beispielsweise eine Diebstahlsicherungseinheit nicht obligatorisch, sondern optional verbaut wird, eröffnen die bisherigen Vorgehensweisen keine Möglichkeit, flexibel auf derartige unterschiedliche Anforderungen reagieren zu können. Hier will die Erfindung insgesamt Abhilfe schaffen.

Der Erfindung liegt das technische Problem zugrunde, einen Komponententräger des eingangs beschriebenen Aufbaus so weiter zu entwickelt, dass sich dieser flexibel an verschiedene Bestückungssituationen des Trägerelementes und folglich Ausrüstungsvarianten eines zugehörigen Kraftfahrzeugtürschlosses unschwer anpassen lässt.

Zur Lösung dieser technischen Problemstellung ist ein gattungsgemäßer Komponententräger zur Aufnahme von elektrischen/elektronischen Bauelementen in insbesondere Kraftfahrzeugtürschlössern dadurch gekennzeichnet, dass die Ausnehmung neben der fußseitig des Anschlusselementes vorgesehenen Öffnung zusätzlich eine seitliche Öffnung aufweist. Im Regelfall verfügt das Anschlusselement hierzu über eine Ausnehmung für das darin aufgenommene eine oder die mehreren elektrischen Bauteile. In der Regel ist eine Ausnehmung für ein zugehöriges elektrisches Bauteil vorgesehen. Das elektrische Bauteil ist dadurch quasi in das Anschlusselement integriert.

Die Auslegung des Anschlusselementes inklusive elektrischem Bauteil als Baueinheit eröffnet den Vorteil, dass je nach Auslegung des elektrischen Bauteils das typischerweise als Anschlussbuchse ausgeführte Anschlusselement mit beispielsweise zwei Kontaktstiften, drei Kontaktstiften oder noch mehr flexibel ausgerüstet wird. Dadurch lassen sich verschiedene Ausrüstungsvarianten des mit dem erfindungsgemäßen Komponententrägers ausgerüsteten Kraftfahrzeugtürschlosses problemlos realisieren. Je nach dem, welches elektrische Bauteil zum Einsatz kommt bzw. an dieser Stelle benötigt wird, verfügt das Anschlusselement über eine korrespondierende Anzahl an Kontaktstiften. Dabei ist die Auslegung meistens so getroffen, dass die elektrische Verbindung zwischen den im Anschlusselement aufgenommenen Kontaktstiften und dem in die Ausnehmung eingesteckten elektrischen Bauteil bei der Vereinigung automatisch hergestellt wird. Das ist selbstverständlich nicht zwingend.

Es hat sich bewährt, wenn die Ausnehmung an einem trägerelementseitigen Ende des Anschlusselementes vorgesehen ist. Das trägerelementseitige Ende des Anschlusselementes korrespondiert regelmäßig zum Fuß des Anschlusselementes. Gegenüberliegend des Fußes des Anschlusselementes ist der Kopf des Anschlusselementes vorgesehen, an den regelmäßig die Anschlussleitungen zu einer entfernten Steuereinheit angeschlossen werden. Für den Fall, dass es sich bei dem Anschlusselement um eine Anschlussbuchse handelt, wird in diese Anschlussbuchse kopfseitig ein Stecker mit den betreffenden Anschlussleitungen eingesteckt.

Das Anschlusselement ist nun mit seinem trägerelementseitigen Ende an das Trägerelement anschließbar ausgebildet. Grundsätzlich kann das Anschlusselement mit seinem trägerelementseitigen Ende auch direkt an das Trägerelement angeschlossen sein oder werden. Die Erfindung favorisiert an dieser Stelle jedoch eine lösbare Verbindung zwischen dem Anschlusselement mit integriertem elektrischen Bauteil einerseits bzw. der Baueinheit aus dem Anschlusselement sowie dem fraglichen Bauteil und dem Trägerelement andererseits. Um diese lösbare Verbindung im Detail zu realisieren, ist das Anschlusselement vorteilhaft mit Anschlusszapfen zur Festlegung am Trägerelement ausgerüstet. Diese Anschlusszapfen können am elektrischen Bauteil ausgebildet sein.

Die Ausnehmung als solche ist erfindungsgemäß als Einschubausnehmung oder Einsteckausnehmung ausgelegt. D. h., das elektrische Bauteil wird in die fragliche Ausnehmung eingeschoben und/oder eingesteckt. Zu diesem Zweck verfügt die Ausnehmung fußseitig des Anschlusselementes über eine dort vorgesehene Öffnung. Meistens sind neben der bereits angesprochenen und fußseitig des Anschlusselementes vorgesehenen Öffnung zusätzlich eine weitere Öffnung oder mehrere weitere Öffnungen realisiert. Erfindungsgemäß verfügt das Anschlusselement neben der bereits angesprochenen und fußseitig vorgesehenen Öffnung zusätzlich über eine Seitenöffnung. Auf diese Weise ist die Ausnehmung regelmäßig als zweiseitig offenes Quader mit L-förmigem Querschnitt ausgebildet.

In der offen quaderförmig ausgelegten Ausnehmung wird das elektrische Bauteil aufgenommen. Dabei ist das elektrische Bauteil meistens so ausgelegt, dass es ein Quader beschreibt bzw. quaderförmig ausgelegt ist. Das quaderförmige Bauteil und die quaderförmige Ausnehmung sind größenmäßig aneinander angepasst.

Auf diese Weise schließt das elektrische Bauteil in seinem in der Ausnehmung aufgenommenen Zustand sowohl mit der im Bereich der Ausnehmung geöffneten Seitenfläche wie auch mit der geöffneten Fußfläche des Anschlusselementes jeweils bündig ab. Dadurch stellt sich der bereits beschriebene gleichsam integrale Charakter des Bauteiles im Anschlusselement quasi von selbst ein.

Wie bereits erläutert, handelt es sich bei dem Anschlusselement vorteilhaft um eine Anschlussbuchse zur Aufnahme eines Steckers. Dieser Stecker ist regelmäßig mit Anschlussleitungen verbunden, die ihrerseits an eine Steuereinheit angeschlossen sind. Bei dem elektrischen Bauteil handelt es sich vorteilhaft um einen Schalter und hier insbesondere einen Mikroschalter. Der Schalter ist regelmäßig zur Abfrage einzelner Stellungen von im Kraftfahrzeugtürschloss befindlichen Elementen ausgebildet. Bei diesen Elementen kann es sich um Hebel, Motoren etc. handeln. Zu diesem Zweck verfügt der Schalter meistens über einen an sein Gehäuse angelenkten Federschenkel, der seinerseits auf einen den Schalter auslösenden Druckknopf arbeitet.

Bei der Herstellung des Kraftfahrzeugtürschlosses wird im Allgemeinen der vergossene Komponententräger in das zugehörige Kraftfahrzeugtürschlossgehäuse eingesetzt. Das Anschlusselement kann nun am Komponententräger lösbar festgelegt werden. Das ist möglich, weil das Anschlusselement und das wenigstens eine Bauteil die an das Trägerelement anschließbare Baueinheit bilden. Zur lösbaren Verbindung dieser Baueinheit mit dem Trägerelement dienen die am elektrischen Bauteil vorgesehenen Anschlusszapfen, welche in zugehörige Zapfenöffnungen am oder im Trägerelement eingreifen.

Beim solchermaßen realisierten Anschlussvorgang erfahren das Anschlusselement und/oder das elektrische Bauteil eine automatische Kontaktierung durch Ihre Verbindung mit dem Trägerelement. Tatsächlich wird hierbei bedarfsweise das Anschlusselement und/oder das elektrische Bauteil mit einem oder mehreren am oder auf dem Trägerelement vorgesehenen elektrischen Leitern verbunden. Das ist jedoch nicht zwingend.

So oder so ist die Baueinheit aus dem Anschlusselement und dem Bauteil getrennt vom Trägerelement mit der etwaigen Vergussumhüllung ausgebildet. Dadurch kann die Baueinheit flexibel an die tatsächlich zur Realisierung des Kraftfahrzeugtürschlosses erforderliche Ausrüstungsvariante angepasst werden.

Beispielsweise ist es denkbar, dass das Kraftfahrzeugtürschloss mit einer Verriegelungseinheit mit einem elektrischen Motor ausgerüstet ist, dessen verschiedene Stellungen bzw. diejenigen der Verriegelungseinheit mit einem oder zwei solcher Schalter abgefragt werden. Falls nun ein solches Kraftfahrzeugtürschloss ergänzend mit einer Diebstahlsicherungseinheit mit zusätzlichem Motor optional ausgerüstet werden soll, so ist dies erfindungsgemäß problemlos dadurch möglich, dass beispielsweise die Abfrage dieser optionalen Diebstahlsicherungseinheit zusätzlich mit Hilfe des elektrischen Bauteils bzw. Schalters als Bestandteil der erfindungsgemäßen Baueinheit aus dem Anschlusselement und dem betreffenden elektrischen Bauteil erfolgt, welche sich in diesem Fall an das Trägerelement anschließen lässt.

Dadurch eröffnet die Erfindung eine flexible Anpassung an unterschiedlich ausgelegte Kraftfahrzeugtürschlösser unter grundsätzlicher Beibehaltung wesentlicher Basiskomponenten, wie des bestückten und vergossenen Trägerelementes. Das gleiche gilt natürlich auch für den Fall, dass auf einen Verguss gänzlich verzichtet wird. Hierin sind die wesentlichen Vorteile zu sehen.

Im Folgenden wird die Erfindung anhand einer lediglich ein Ausführungsbeispiel darstellenden Zeichnung näher erläutert; es zeigen:
- **Fig. 1**: ein Kraftfahrzeugtürschloss mit eingebautem erfindungsgemäßen Komponententräger,
- **Fig. 2**: den Komponententräger in einer Einzeldarstellung und
- **Fig. 3**: ein Detail des Komponententrägers in verschiedenen Varianten.

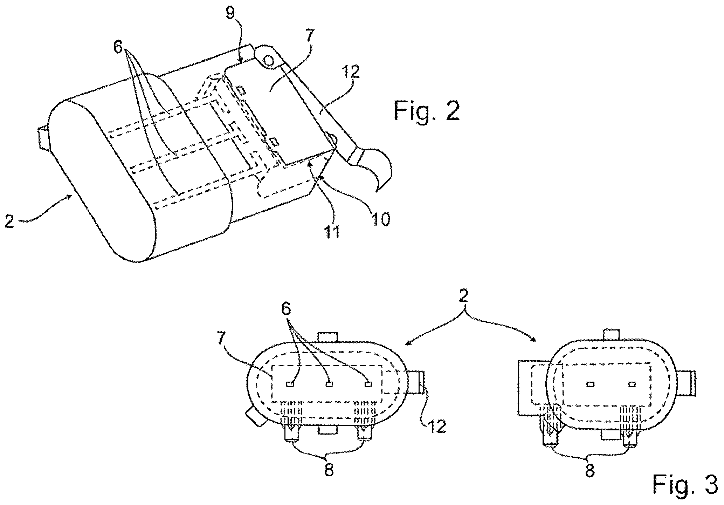

In den Figuren ist ein Kraftfahrzeugtürschloss mit einem darin aufgenommenen Komponententräger 1 dargestellt. Der Komponententräger 1 ist für sich genommen noch einmal separat und teilweise in der Fig. 2 wiedergegeben und wird insgesamt in einem Kraftfahrzeugtürschloss-Gehäuse G zusammen mit Hebeln oder anderen Elementen aufgenommen. Außerdem erkennt man ein elektrisches Anschlusselement 2, bei dem es sich um eine Anschlussbuchse 2 handelt, die zur Aufnahme eines nicht näher gezeigten Steckers dient. Der Stecker ist mit Anschlussleitungen verbunden, die ihrerseits an eine ebenfalls nicht gezeigte Steuereinheit angeschlossen sind bzw. mit dieser eine elektrische Verbindung eingehen.

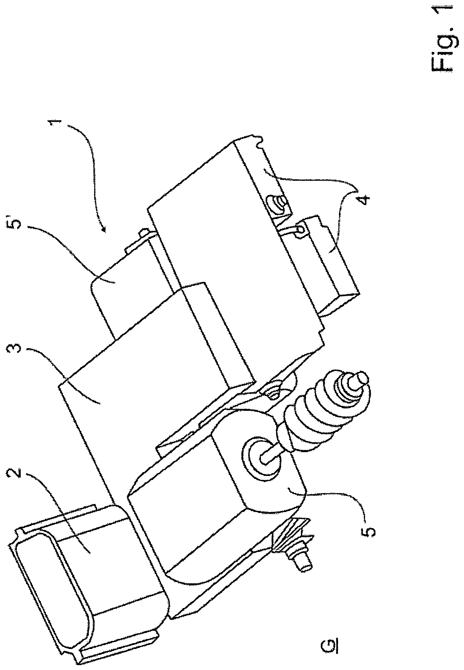

Neben dem bereits besprochenen Anschlusselement 2 gehört zum grundsätzlichen Aufbau des Komponententrägers 1 noch ein meistens flächig ausgebildetes Trägerelement 3, welches beispielsweise ausweislich der Fig. 1 verschiedene elektrische Bauteile 4 trägt. Bei diesen elektrischen Bauteilen 4 handelt es sich um Schalter bzw. Mikroschalter 4. Darüber hinaus dient das Trägerelement 3 zur Aufnahme und Halterung zweier Elektromotoren 5, 5 die schematisch in der Fig. 2 angedeutet sind. Auf diese Weise ist das Trägerelement 3 zur Aufnahme des Anschlusselementes 2, der elektrischen Bauteile 4 und schließlich der Elektromotoren 5', 5 eingerichtet, was selbstverständlich nur beispielhaft gilt und nicht zwingend ist.

Schließlich gehören zum grundsätzlichen Aufbau des Komponententrägers 1 auch noch ein oder mehrere elektrische Leiter 6, die sich im Ausführungsbeispiel überwiegend als Kontaktstifte 6 im Innern des Anschlusselementes 2 manifestieren (vgl. Fig. 2). Neben diesen explizit dargestellten elektrischen Leitern 6 kann grundsätzlich noch ein nicht ausdrücklich gezeigtes Leiterbahngebilde realisiert sein, welches vom Trägerelement 3 getragen wird. Mit Hilfe der elektrischen Leiter 6 wird das Anschlusselement 2 und/oder ein weiteres elektrisches Bauteil 7 kontaktiert, und zwar im Ausführungsbeispiel und über den nicht dargestellten Stecker mit der entfernt angeordneten elektronischen Steuereinheit elektrisch verbunden.

Erfindungsgemäß bilden nun das Anschlusselement 2 und das wenigstens eine Bauteil 7 eine an das Trägerelement 3 anschließbare Baueinheit 2, 7. Grundsätzlich kann die Baueinheit 2, 7 auch fest an das Trägerelement 3 angeschlossen werden, was im Ausführungsbeispiel jedoch nicht dargestellt ist. Hier erkennt man vielmehr die Situation, dass die Baueinheit 2, 7 mit Anschlusszapfen 8 ausgerüstet ist, welche in nicht näher dargestellte Öffnungen im Trägerelement 3 bzw. eine entsprechende Trägerelementplatte lösbar eingreifen. Dadurch lässt sich die Baueinheit 2, 7 nachträglich und wahlweise an das Trägerelement 3 mechanisch anschließen, wobei das Trägerelement 3 zuvor mit den elektrischen Leitern bzw. dem Leiterbahngebilde den weiteren elektrischen Bauteilen 4 und auch den Elektromotoren 5, 5' ausgerüstet und gegebenenfalls mit Vergussmasse umhüllt worden ist.

Die nachträgliche Anbringung der Baueinheit 2, 7 aus dem Anschlusselement 2 und dem elektrischen Bauteil 7 bzw. dem weiteren Schalter respektive Mikroschalter 7 an dem Trägerelement 3 ist regelmäßig dann erforderlich, wenn das in der Fig. 1 prinzipiell dargestellte Kraftfahrzeugtürschloss mit einer hier nicht gezeigten Diebstahlsicherungseinheit aufgerüstet wird oder aufgerüstet werden soll. Von dieser Diebstahlsicherungseinheit erkennt man in der Fig. 1 lediglich den Diebstahlsicherungsmotor bzw. Elektromotor 5'. Mit Hilfe des elektrischen Bauteils 7 bzw. des an dieser Stelle realisierten Schalters oder Mikroschalters 7 wird im Beispielfall die Diebstahlsicherungseinheit hinsichtlich ihrer eingenommenen Positionen abgefragt bzw. der zugehörige Elektromotor respektive Diebstahlsicherungsmotor 5'. Das gilt selbstverständlich nur beispielhaft.

Die bereits angesprochene Baueinheit 2, 7 aus dem Anschlusselement 2 und dem elektrischen Bauteil bzw. Mikroschalter 7 wird im Detail so umgesetzt und realisiert, dass das Anschlusselement 2 mit einer Ausnehmung 9 für das darin aufgenommene Bauteil 7 ausgerüstet ist. Insbesondere anhand der Darstellung in der Fig. 2 erkennt man, dass die Ausnehmung 9 an einem trägerelementseitigen Ende des Anschlusselementes 2 vorgesehen ist. Mit diesem trägerelementseitigen Ende lässt sich das Anschlusselement 2 bzw. die Baueinheit 2, 7 aus dem Anschlusselement 2 und dem elektrischen Bauteil 7 an das Trägerelement 3 anschließen, nämlich über die bereits angesprochenen Anschlusszapfen 8. Diese Anschlusszapfen 8 finden sich zu diesem Zweck an dem elektrischen Bauteil 7 bzw. sind hieran ausgebildet, wie die ergänzend in der Fig. 3 wiedergegebene teilweise Schnittdarstellung deutlich macht.

Mit Hilfe der Anschlusszapfen 8 wird das Anschlusselement 2 bzw. wird die bereits angesprochene Baueinheit 2, 7 an dem Trägerelement 3 lösbar festgelegt. Bei diesem Vorgang kann es ergänzend zu einer elektrischen Verbindung bzw. eine automatischen Kontaktierung mit den nicht näher dargestellten und vom Trägerelement 3 getragenen Leiterbahngebilde kommen. D. h., das Anschlusselement 2 und/oder das elektrische Bauteil 7 erfahren bei der Verbindung der Baueinheit 2, 7 mit dem Trägerelement 3 bedarfsweise eine automatische Kontaktierung. In jedem Fall ist die Baueinheit 2, 7 aus dem Anschlusselement 2 und dem elektrischen Bauteil bzw. Mikroschalter 7 getrennt vom eigentlichen Trägerelement 3 mit etwaiger Vergussumhüllung ausgebildet.

Zur Realisierung bzw. Definition der Baueinheit 2, 7 ist die bereits angesprochene Ausnehmung 9 zur Aufnahme des fraglichen elektrischen Bauteiles 7 insgesamt als Einschubausnehmung oder Einsteckausnehmung ausgelegt. Dazu verfügt die Ausnehmung 9 über eine Öffnung 10 fußseitig des Anschlusselementes 2. Neben dieser fußseitigen Öffnung 10 ist regelmäßig auch eine seitliche Öffnung 11 bzw. Seitenöffnung 11 vorgesehen. Auf diese Weise besitzt die Ausnehmung 9 einen L-förmigen Querschnitt und ist insgesamt als zweiseitig offenes Quader ausgebildet.

Das in der Ausnehmung 9 aufgenommene elektrische Bauteil 7 verfügt ebenfalls über einen quaderförmigen Charakter bzw. ist als Quader ausgelegt. Dabei ist die Ausführung insgesamt so getroffen, dass die offen quaderförmig ausgebildete Ausnehmung 9 und das hierin aufgenommene ebenfalls quaderförmige elektrische Bauteil 7 von ihren Abmessungen her jeweils aneinander angepasst sind. Dadurch schließt das in der Ausnehmung 9 in aufgenommenem Zustand befindliche elektrische Bauteil 7 mit der im Bereich der Ausnehmung 9 geöffneten Seitenfläche bündig ab. Ebenso wird ein bündiger Abschluss im Bereich der geöffneten Fußfläche des Anschlusselementes 2 beobachtet. Dadurch ist das elektrische Bauteil bzw. der Schalter 7 gleichsam in das Anschlusselement bzw. die an dieser Stelle realisierte Anschlussbuchse 2 integriert.

Im Ausführungsbeispiel verfügt der Schalter 7 über einen hieran im Sinne eines Einarmhebels gelagerten Federschenkel 12. Der Federschenkel 12 tastet den Motor 5' bzw. von ihm beaufschlagte Abtriebselemente ab. Wird der Federschenkel 12 an den Schalter 7 angelegt, erfährt dieser eine Beaufschlagung und wechselt seinen Schalterzustand, was wiederum mit Hilfe einer nicht gezeigten Steuereinheit registriert werden kann.

## Patentansprüche

1. Komponententräger zur Aufnahme von elektrischen/elektronischen Bauelementen (2, 4, 5, 5', 6, 7) in insbesondere Kraftfahrzeugtürschlössern, mit zumindest einem elektrischen Anschlusselement (2), ferner mit wenigstens einem Trägerelement (3), und mit einem oder mehreren elektrischen Leitern (6) zur elektrischen Kontaktierung des Anschlusselementes (2) und/oder eines elektrischen Bauteils (4, 7), wobei das Anschlusselement (2) und das wenigstens eine elektrische Bauteil (7) eine an das Trägerelement (3) angeschlossene Baueinheit (2, 7) bilden, wobei das Anschlusselement (2) eine Ausnehmung (9) für das darin aufgenommene Bauteil (7) aufweist, wobei die Ausnehmung (9) als Einschubausnehmung oder Einsteckausnehmung mit fußseitig des Anschlusselementes (2) vorgesehener Öffnung (10) ausgebildet ist, **dadurch gekennzeichnet, dass** die Ausnehmung (9) neben der fußseitig des Anschlusselementes (2) vorgesehenen Öffnung (10) zusätzlich eine seitliche Öffnung (11) aufweist.

2. Komponententräger nach Anspruch 1, **dadurch gekennzeichnet, dass** die Ausnehmung (9) an einem trägerelementseitigen Ende des Anschlusselementes (2) vorgesehen ist.

3. Komponententräger nach Anspruch 2, **dadurch gekennzeichnet, dass** das Anschlusselement (2) mit seinem trägerelementseitigen Ende an das Trägerelement (3) anschließbar ausgebildet oder angeschlossen ist.

4. Komponententräger nach einem der vorhergehenden Ansprüche, **dadurch gekennzeichnet, dass** die Ausnehmung (9) als zweiseitig offenes Quader mit L-förmigem Querschnitt ausgebildet ist.

5. Komponententräger nach Anspruch 4, **dadurch gekennzeichnet, dass** das in der offen quaderförmig ausgelegten Ausnehmung (9) aufgenommene elektrische Bauteil (7) als hieran angepasstes Quader ausgebildet ist.

6. Komponententräger nach einem der vorhergehenden Ansprüche, **dadurch gekennzeichnet, dass** das elektrische Bauteil (7) in in der Ausnehmung (9) aufgenommenem Zustand mit der im Bereich der Ausnehmung (9) geöffneten Seitenfläche ebenso wie mit der geöffneten Fußfläche des Anschlusselementes (2) jeweils im Wesentlichen bündig abschließt.

7. Komponententräger nach einem der Ansprüche 1 bis 6, **dadurch gekennzeichnet, dass** die Baueinheit (2, 7) mit Anschlusszapfen (8) zur Festlegung am Trägerelement (3) ausgerüstet ist.

8. Komponententräger nach Anspruch 7, **dadurch gekennzeichnet, dass** die Anschlusszapfen (8) am elektrischen Bauteil (7) ausgebildet sind.

9. Komponententräger nach einem der Ansprüche 1 bis 8, **dadurch gekennzeichnet, dass** das Anschlusselement (2) als Anschlussbuchse (2) zur Aufnahme eines Steckers ausgebildet ist.

10. Komponententräger nach einem der Ansprüche 1 bis 9, **dadurch gekennzeichnet, dass** das elektrische Bauteil (7) als Schalter, insbesondere Mikroschalter (7), ausgelegt ist.

11. Komponententräger nach Anspruch 10, **dadurch gekennzeichnet, dass** der Schalter (7) zur Abfrage einzelner Stellungen von im Kraftfahrzeugtürschloss befindlicher Elemente wie Hebel, Motoren (5, 5') etc. ausgebildet ist und dazu einen Federschenkel (12) aufweist.

12. Komponententräger nach einem der Ansprüche 1 bis 11, **dadurch gekennzeichnet, dass** das Anschlusselement (2) und/oder das elektrische Bauteil (7) bei ihrer Verbindung mit dem Trägerelement (3) eine automatische Kontaktierung erfahren.

13. Komponententräger nach einem der Ansprüche 1 bis 12, **dadurch gekennzeichnet, dass** die Baueinheit (2, 7) aus dem Anschlusselement (2) und dem elektrischen Bauteil (7) getrennt vom Trägerelement (3) mit etwaiger Vergussumhüllung ausgebildet ist.

## Claims

1. Component carrier for the accommodation of electrical/electronic components (2, 4, 5, 5', 6, 7) in particular motor vehicle door latches with at least an electrical connection element (2), furthermore with at least a carrier element (3), and with one or several electrical conductors (6) for electrical contact of the connection element (2) and/or an electrical component (4, 7), whereby the connection element (2) and the at least one electrical component (7) form a constructional unit (2, 7) connected to the carrier element (3), whereby the connection element (2) demonstrates a recess (9) for the accommodated component (7), whereby the recess (9) is formed as a slide-in recess or a plug-in recess with an aperture (10) provided for on the base of the connection element (2), **characterized in that** the recess (9) demonstrates a lateral aperture (11) in addition to the aperture (10) provided for on the base of the connection element (2).

2. Component carrier according to claim 1, **characterized in that** the recess (9) is provided for on a carrier element-side end of the connection element (2).

3. Component carrier according to claim 2, **characterized in that** the connection element (2) is be designed as connectable or is connected with its carrier element side-end to the carrier element (3).

4. Component carrier according to one of the previous claims, **characterized in that** the recess (9) is formed as a cuboid open on two sides with an L-shaped cross-section.

5. Component carrier according to claim 4, **characterized in that** the electrical component (7) accommodated in the recess (9) of an open cuboid-shaped design is formed as a cuboid adapted thereto.

6. Component carrier according to one of the previous claims, **characterized in that** the electrical component (7) in the state accommodated in the recess (9) essentially ends flush in each instance with the lateral surface open in the area of the recess (9) and with the open base surface of the connection element (2).

7. Component carrier according to one of the claims 1 to 6, **characterized in that** the constructional unit (2, 7) is equipped with a connecting pin (8) for fixing to the carrier element (3).

8. Component carrier according to claim 7, **characterized in that** the connecting pin (8) is formed on the electrical component (7).

9. Component carrier according to claims 1 to 8, **characterized in that** the connection element (2) is formed as a connection socket (2) to accommodate a plug.

10. Component carrier according to one of the claims 1 to 9, **characterized in that** the electrical component (7) is designed as a switch, in particular a microswitch (7).

11. Component carrier according to claim 10, **characterized in that** the switch (7) is formed for querying individual positions of elements in the motor vehicle door latch such as levers, motors (5, 5') etc. and demonstrates a spring leg (12).

12. Component carrier according to one of the claims 1 to 11, **characterized in that** the connection element (2) and/or the electrical component (7) experience automatic contacting in their connection with the carrier element (3).

13. Component carrier according to one of the claims 1 to 12, **characterized in that** the constructional unit (2, 7) comprising the connection element (2) and the electrical component (7) are formed separately from the carrier element (3) with any casting sheath.

## Revendications

1. Support de composants destiné à recevoir des composants électriques/électroniques (2, 4, 5, 5', 6, 7), en particulier dans des serrures de portes de véhicules à moteur, qui comporte au moins un élément de connexion électrique (2) ainsi qu'au moins un élément support (3) et un ou plusieurs conducteurs électriques (6) servant à la connexion électrique de l'élément de connexion (2) et/ou d'un composant électrique (4, 7), l'élément de connexion (2) et au moins un composant électriques (7) formant une unité de composants (2, 7) connectée à l'élément support (3), l'élément de connexion (2) présentant un creux (9) pour le composant (7) s'y trouvant, le creux (9) étant formé comme creux d'insertion ou creux d'enfichage avec côté pied l'élément de connexion (2) de l'ouverture prévue (10) **caractérisé en ce que** le creux (9) outre l'ouverture prévue (10) au côté pied de l'élément de connexion (2) présente en plus une ouverture latérale (11).

2. Support de composants selon la revendication 1 **caractérisé en ce que** le creux (9) est prévu à une extrémité côté élément de support de l'élément de connexion (2).

3. Support de composants selon la revendication 2 **caractérisé en ce que** l'élément de connexion (2) avec son extrémité côté élément de support est formé de façon raccordable ou raccordé à l'élément de support (3).

4. Support de composants selon l'une des revendications précédentes **caractérisé en ce que** le creux (9) est formé comme un parallélépipède ouvert des deux côtés avec une section en forme de L.

5. Support de composants selon la revendication 4 **caractérisé en ce que** l'élément électrique (7) logé dans le creux (9) dimensionné de façon ouverte et en forme de parallélépipède est formé comme parallélépipède adapté à celui-ci.

6. Support de composants selon l'une des revendications précédentes **caractérisé en ce que** l'élément électrique (7) se termine essentiellement à fleur de l'état pris dans le creux (9) avec la surface latérale ouverte dans la zone du creux (9) ainsi qu'avec l'embase ouverte de l'élément de connexion (2).

7. Support de composants selon l'une des revendications 1 à 6 **caractérisé en ce que** l'unité de composant (2, 7) est équipée de tenon de connexion (8) pour fixation à l'élément support (3).

8. Support de composants selon la revendication 7 **caractérisé en ce que** le tenon de connexion (8) est formé à l'élément électrique (7).

9. Support de composants selon l'une des revendications 1 à 8 **caractérisé en ce que** l'élément de connexion (2) est formé comme douille de connexion (2) pour loger une fiche.

10. Support de composants selon l'une des revendications 1 à 9 **caractérisé en ce que** l'élément électrique (7) est dimensionné comme interrupteur, en particulier micro-interrupteur (7).

11. Support de composants selon la revendication 10 **caractérisé en ce que** l'interrupteur (7) est formé pour interrogation de positions de différents éléments se trouvant dans la serrure de porte de véhicule comme levier, moteurs (5, 5') etc. et à cet effet présente une branche à ressort (12).

12. Support de composants selon l'une des revendications 1 à 11 **caractérisé en ce que** l'élément de connexion (2) et/ou l'élément électrique (7) sont soumis à un contact automatique lors de leur connexion avec l'élément de support (3).

13. Support de composants selon l'une des revendications 1 à 12 **caractérisé en ce que** l'unité de composants (2, 7) est formée à partir de l'élément de connexion (2) et l'élément électrique (7) séparément de l'élément de support (3) avec une éventuelle enveloppe coulée.
